(19) Europäisches Patentamt
European Patent Office
Office européen des brevets

(11) Veröffentlichungsnummer: **0 502 523 A2**

# EUROPÄISCHE PATENTANMELDUNG

(21) Anmeldenummer: **92103772.7**

(51) Int. Cl.⁵: **H01L 21/302**

(22) Anmeldetag: **05.03.92**

(30) Priorität: **05.03.91 DE 4107006**

(43) Veröffentlichungstag der Anmeldung:
**09.09.92 Patentblatt 92/37**

(84) Benannte Vertragsstaaten:
**BE DE GB IT NL**

(71) Anmelder: **SIEMENS AKTIENGESELLSCHAFT**
**Wittelsbacherplatz 2**
**W-8000 München 2(DE)**

(72) Erfinder: **Frank, Wolfgang E., Dipl.-Ing.**
**Nelkenstrasse 7**
**W-8043 Unterföhring(DE)**

(54) **Verfahren zum anisotropen Trockenätzen von Aluminium bzw. Aluminiumlegierungen enthaltenden Leiterbahnebenen in integrierten Halbleiterschaltungen.**

(57) Bei einem Verfahren zum anisotropen Trockenätzen von Aluminium bzw. Aluminiumlegierungen enthaltenden Leiterbahnebenen in integrierten Halbleiterschaltungen, bei dem eine Ätzmaske (9) verwendet wird, erfolgt das Ätzen mit einer streng anisotrop angreifenden Ätzgasmischung, die eine bei Normalbedingungen flüchtige Jodverbindung enthält, wobei eine genau definierte vertikale Flankenform (10) der Leiterbahnen ausgebildet wird. Auf diese Weise ist es möglich, Aluminiumleiterbahnen zu erhalten, die strenge Maßhaltigkeit und Korrosionsfestigkeit des Ätzprofils aufweisen, ohne die sonst übliche Seitenwandpassivierung zu erfordern.

## FIG 2

Die Erfindung betrifft ein Verfahren zum anisotropen Trockenätzen von Aluminium bzw. Aluminiumlegierungen enthaltenden Leiterbahnebenen in integrierten Halbleiterschaltungen, bei dem eine Ätzmaske verwendet wird, sowie dessen Verwendung.

Zum Stand der Ätztechnik wird auf Kapitel 5 des Buches "Technologie hochintegrierter Schaltungen", 1988, von D. Widmann, H. Mader und H. Friedrich (vgl. insb. Abschnitte 5.2.3, 5.2.5 und 5.3.6) hingewiesen.

Aluminium- bzw. Aluminiumlegierungsschichten werden aufgrund ihrer überlegenen Materialeigenschaften (niedriger Widerstand, kleiner Kontaktwiderstand, gute Adhäsion von darüberliegenden Dielektrika, Selbstpassivierungsfähgikeit durch Bildung einer natürlichen Oxidschicht, Eignung für Mehrlagenmetallisierung) und gut funktionierender Abscheideverfahren mit guter Kantenbedeckung seit Beginn der VLSI-Technik als Leiterbahnmaterial verwendet. Die Al-Schichten mit Dicken im Bereich von ca. 1-2 $\mu$m, denen geringe Mengen von z. B. Silizium und Kupfer beigemengt sein können, werden meist durch Sputtern erzeugt. Gegenwärtig werden vielfach mehrlagige Metallisierungsschichten verwendet, die beispielsweise den Aufbau Al/TiN/Ti haben können, wobei oberhalb der Al-Schicht eine $SiO_2$-Schicht (z.B. als Isolationsschicht gegen darüberliegende weitere Metallebenen) vorgesehen sein kann.

Zur Erzeugung von feinen Strukturen der Al-Leiterbahnebenen im Zuge der Fertigung von integrierten Schaltungen werden praktisch ausschließlich plasmaunterstützte Ätzprozesse (Trockenätzen) eingesetzt. Dabei befindet sich auf der zu strukturierenden Al-Schicht bereits eine strukturierte Schicht, z. B. aus Photolack, als Ätzmaske. Grundsätzlich geht es darum, das Muster der Ätzmaske möglichst maßhaltig in die darunterliegende Schicht (die Al-Leiterbahnebene) zu übertragen. Die Ätzung soll im allgemeinen selektiv zur folgenden Schicht erfolgen, diese also nicht anätzen.

Als Trockenätzprozeß kommt zunächst das plasmaunterstützte chemische Ätzen, z. B. in einem konventionellen Barrelreaktor (vgl. Widman et al, S. 194 f.) in Frage. Als Ätzmittel werden dabei Gase, hauptsächlich fluor-, chlor- und bromhaltige Verbindungen, verwendet, die mit dem Material der zu entfernenden Schicht ein gasförmiges, flüchtiges Reaktionsprodukt bilden. Im Ätzreaktor wird durch eine Gasentladung ein Plasma erzeugt. In der Folge diffundieren im Plasma entstandene neutrale reaktive Teilchen (Radikale) zu den im Reaktor befindlichen Substratscheiben und reagieren in vielen Fällen spontan und exotherm mit den Atomen der zu ätzenden Oberfläche. Das Reaktionsprodukt diffundiert anschließend von der Scheibe weg. Da die Bewegungsrichtung der neutralen Teilchen beim chemischen Ätzen im allgemeinen isotrop verteilt ist, erfolgt der Ätzangriff isotrop und führt deshalb zur Unterätzung der Ätzmaske, d.h. zu einem isotropen Ätzprofil. Rein chemische Ätzverfahren eignen sich deshalb nicht zur Erzeugung von sehr feinen Strukturen.

Zur Erzeugung von sehr feinen Strukturen werden heute verschiedene Verfahren des plasmaunterstützten physikalisch-chemischen Ätzens, wie RIE (Reactive Ion Etching), MERIE (Magnetical Enhanced RIE) oder ECR (Electron Cyclotron Resonance) eingesetzt. Um die isotrope Ätzkomponente gering zu halten und ein mehr oder weniger anisotropes Ätzprofil zu erzielen, machen diese Ätzverfahren von zusätzlichen physikalischen Hilfsmitteln Gebrauch. Beim reaktiven Ionenätzen (RIE) soll die chemische Ätzreaktion möglichst nur durch im Plasma erzeugte, senkrecht zur Ätzoberfläche einfallende Ionen ausgelöst werden. Die so entstehende senkrechte, anisotrope Ätzkomponente eröffnet zwar grundsätzlich die Möglichkeit anisotropen Ätzens, jedoch hängt das tatsächliche Ätzprofil von einer Vielzahl von Faktoren ab und ist fast immer durch eine isotrope Ätzkomponente mitbestimmt, die durch die verschiedenen Hilfsmittel (z.B. Magnetfeldunterstützung, niedriger Arbeitsdruckbereich) nicht völlig eliminiert werden kann.

Die Wahl der als Ätzgas verwendeten, zu einem flüchtigen Reaktionsprodukt führenden Verbindung, des speziellen Reaktortyps und der speziellen Prozeßbedingungen erfolgt mit Blick auf die für den jeweiligen Anwendungsfall maßgeblichen Aspekte des Ätzprozesses bzw. Ätzergebnisses (u.a. Ätzprofil, Ätzrate, Selektivität, Scavenging-Eigenschaften, Polymerbildung, Flüchtigkeit und Aggressivität der Reaktionsprodukte, Damage der Kristallgitterstruktur, Korrosion). Das Ergebnis des Ätzprozesses ist primär durch die Interaktion der beiden Komponenten Ätzgaszusammensetzung und zu ätzendes Material bestimmt; für die in der Halbleiterindustrie in vielen Variationen verwendeten Siliziumschichten und Metallschichten liegen für die jeweiligen Schicht/Schicht/Ätzgas-Systeme sehr unterschiedliche Erfahrungswerte vor.

Eine notwendige Voraussetzung bei der chemischen Ätzreaktion ist, wie erwähnt, die Bildung eines gasförmigen, flüchtigen Reaktionsprodukts. Stand der Technik beim Ätzen von Aluminium ist die Verwendung der Halogene Chlor und Brom, wobei als Chlor- bzw. Bromlieferanten eine Vielzahl von Verbindungen mit jeweils spezifischen Vor- und Nachteilen bekannt sind. Fluor kommt zum Ätzen von Aluminium nicht in Frage, da es mit diesem erst bei sehr hoher Temperatur ein flüchtiges Reaktionsprodukt bildet. Um die spezifischen Vorteile verschiedener Gase auszunützen, wird bei den meisten gegenwärtig eingesetzten Ätzprozessen eine Ätzgasmischung verwendet. Gebräuchlich sind z. B. Mischungen aus $CCl_4/Cl_2$, $BCl_3/Cl_2$, $SiCl_4/Cl_2$, $SiCl_4/BCl_3/Cl_2$, $BCl_3/CHCl_3/Cl_2$ mit $N_2$- und He-Träger, $BCl_3/Cl_2/CH_4$ und $BBr_3/HBr$.

Die Gase $CCl_4$, $CHCl_3$, $SiCl_4$, sowie Chlor- bzw. Bromwasserstoff sind für ein eher anisotropes Ätzprofil geeignet, während molekulares Chlor bzw. Brom jeweils rein isotrop ätzen. Bromhaltige Ätzgase haben im Gegensatz zu chlorhaltigen den Vorteil einer verbesserten Lackselektivität.

Auf jodhaltiger Chemie basierende Aluminium-Ätzprozesse sind bisher nicht bekannt geworden. Ein wirtschaftlicher und prozeßtechnisch sinnvoller Einsatz von molekularem Jod ($J_2$) als Ätzgas muß von vorneherein ausgeschlossen werden, da Jod bei Zimmertemperatur ein Feststoff ist und erst bei 150° C einen Dampfdruck vom ca. 50.000 Pa aufweist, der Voraussetzung für einen ausreichenden Gasfluß ist. Es müßten mithin der komplette Gaspfad (mehr als 10 m) samt Jodtank und Ätzkammer auf 150° C erhitzt werden, was technisch gar nicht oder nur mit sehr großem Aufwand durchführbar ist. Eine derart hohe Temperatur ist auch insofern problematisch, als der Fotoresist (Ätzmaske) normalerweise nur bis ca. 120° C erwärmt werden darf. Da ferner unseres Wissens nur sehr wenige bei Normalbedingungen flüchtige Jodverbindungen, nämlich Jodwasserstoff und problematische Interhalogene, z. B. $JF_7$, bekannt sind, scheint eine auf Jod beruhende Ätz-Chemie von vorneherein keine Perspektiven und Variationsmöglichkeiten zu bieten. Es ist deshalb auch lediglich hinsichtlich des reaktiven Ionenätzens von Siliziumschichten und von Zinnschichten auf Halbleitersubstraten in den letzten Jahren der Einsatz von Jodwasserstoff als Ätzgas vorgeschlagen worden.

In der EP-A-0 272 143 wird das Ätzen nach dem MERIE-Verfahren von Silizium und Siliziden mittels brom- und jodhaltiger Chemie beschrieben. Die Autoren streben im Hinblick auf die Erzeugung von Trenches im ULSI-Bereich einen Ätzprozeß an, der sich durch die Optimierung der Ätzrate, der Selektivität zur Maske und des Aspektverhältnisses auszeichnet. Außerdem soll "black silicon formation" verhindert werden, bei der durch Kontamination mit lokalen Restoxiden unerwünschte Mikromasken entstehen, unter denen nicht ausreichend geätzt wird. In der Patentanmeldung wird ein Abgehen von der bisher bei Siliziumschichten üblichen speziellen chlorhaltigen Chemie ausdrücklich deshalb vorgeschlagen, da Chlorgase zu stark anisotrop ätzen, um ein in diesem Fall erwünschtes Unterätzen der Mikromasken bewirken zu können. Im Zusammenhang mit Polysilizium-Silizid-Doppelschichten wird zudem festgestellt, daß mit der neu vorgeschlagenen Chemie die obengenannten Eigenschaften des Ätzprozesses optimiert werden können, während andererseits eine ausreichende Anisotropie bereits durch die bisher bekannte chlorhaltige Komponente der Ätzzusammensetzung gewährleistet werden könne. In der US-PS 47 08 766 soll Wasserstoffjodid zum RIE-Ätzen von Zinnschichten gerade wegen seiner besonders isotropen Ätzeigenschaften eingesetzt werden. Als Material für eine - gegenüber Jodwasserstoff resistente - Ätzmaske wird unter anderem Aluminium erwähnt.

Für die Übertragung von extrem kleinen Strukturen (neue Designs in der ULSI-Technologie zielen auf Strukturdimensionen im Submikronbereich) muß von einem Ätzprozeß perfekte Anisotropie verlangt werden. (f = I; vgl. Widmann et al, Seite 189). Da rein physikalische Ätzprozesse (Sputterätzen), die generell eine nicht vertikale Flankenform mit starkem Taper aufweisen, ausscheiden und physikalisch-chemische Verfahren immer auch eine isotrope Ätzkomponente erwarten lassen, müssen zur Erzielung eines wirklich streng anisotropen Ätzprofiles bisher immer zusätzliche Maßnahmen ergriffen werden. Um die gewünschte perfekte Anisotropie zu erreichen, ist es Stand der Technik (vgl. z. B. D. Bollinger et al, "Reactive Ion Etching: It's Basis and Future", Solid State Technology/May 1984, S. 111-117), das gerade teilweise geätzte Profil mit einer gegen den Angriff des Ätzgases (beispielsweise $CCl_4$) schützenden Passivierungsschicht zu überziehen. Diese Passivierungsschicht besteht aus Polymerprodukten entweder des Ätzgases selbst, oder von, der Ätzgasmischung zu diesem Zweck beigemischten, Halocarbonen. Die Passivierungsschichten, die sich senkrecht zur Einfallrichtung der Ionen über den zu ätzenden Bereichen der Aluminiumschicht ausbilden, werden durch die Ionen sofort wieder physikalisch entfernt, so daß der Ätzprozeß unbehindert in die Tiefe fortschreitet.

Die sich an den vertikalen Aluminium-Seitenwänden, die gemäß dem Ätzmuster während des zunehmend tiefer gehenden Ätzens entstehen, anlagernden Passivierungsschichten (Seitenwandpassivierung) bleiben andererseits jedoch unbeschädigt, da sie von keinen Ionen getroffen werden, die zum Auslösen einer Reaktion genügend große Energie besitzen. Die Seitenwandpassivierung garantiert durch Verhinderung des Unterätzens ein perfekt anisotropes Ätzprofil mit vertikaler Flankenform bei den sich ausbildenden Aluminiumstrukturen. Der Passivierungsmechanismus kann durch Reaktionsprodukte der Lackmaske mit dem Ätzgas unterstützt werden.

Der bisher notwendige Einsatz einer Seitenwandpassivierung ist aus verschiedenen Gründen äußerst problematisch. Zum einen werden der Prozeßwafer und die Ätzkammer durch die Polymere stark verschmutzt. Desweiteren ist die Dicke der Seitenwandschicht schwer zu kontrollieren. Bei zu dünner Passivierung reißt der Seitenwandfilm und die Anisotropie geht durch lateralen Angriff des Ätzmittels verloren. Die Passivierungsschicht muß also genügend dick gehalten werden, um einen unterätzenden Angriff der Aluminiumstruktur durch das Ätzgas zu verhindern. Der dadurch entstehende Maßgewinn in den kritischen Strukturen ("CD-gain") von bis zu 0,2 $\mu$m kann bei Strukturdimensionen im Submikronbereich nicht mehr toleriert werden. Ein weiteres Problem ergibt sich daraus, daß bei der Abscheidung der Polymerschicht durch die Ätzung ein gewisser Anteil chlor- bzw. bromhaltiger Spezies eingebaut wird. Wird die Substratscheibe nach der Ätzung aus dem Reaktor genommen, reagieren diese Halogenspezies mit der Umgebungsfeuchtigkeit und den Aluminiumstrukturen unter Bildung von Aluminium(hydr)oxiden und zerstören im Zuge einer selbsterhaltenden Korrosionsreaktion das Ätzprofil. Die zur Vermeidung von Korrosion verwendeten Nachbehandlungsschritte (z. B. Wasserspülung, In-situ-Lackstrippen, Ausheizen der Scheibe, Passivierung im Fluorplasma) sind zeitintensiv, teuer und damit unwirtschaftlich. In vielen Fällen ist im übrigen trotzdem kein vollständiger Schutz gegen Korrosion zu erzielen.

Zur Problematik des Ätzprozesses gehört es im übrigen auch, daß die Ätzchemie so zusammengesetzt sein muß, daß die natürliche Aluminiumoxidschicht gut weggeätzt wird und daß das Ätzgas den in der Kammer verbliebenen Restsauerstoff und Feuchtigkeit zu binden vermag (Scavanging) um so die Neubildung der Aluminiumoxidschicht zu verhindern. Schließlich ist auch zu bedenken, daß beim Ätzen mit der bisher üblichen Chlorchemie die Ti/TiN-Barriere einer mehrlagigen Metallisierungsschicht zwar automatisch im Hauptätzschritt mit der Aluminiumschicht entfernt wird, daß dabei jedoch Probleme mit der Homogenität der Ätzung über die Ätzfläche auftreten.

Aufgabe der Erfindung ist es, ein Verfahren der eingangs genannten Art anzugeben, das einen einfachen, flexiblen, korrosionsfreien, perfekt anisotropen und maßhaltigen Ätzprozeß für Anwendungen insbesondere im Submikronbereich zur Verfügung stellt.

Die erfindungsgemäße Aufgabe wird durch ein Verfahren der eingangs genannten Art gelöst, das gekennzeichnet ist durch das Ätzen mit einer streng anisotrop angreifenden Ätzgasmischung, die eine bei Normalbedingungen flüchtige Jodverbindung enthält, wobei eine genau definierte vertikale Flankenform der Leiterbahnen ausgebildet wird. Mit Wasserstoffjodid steht eine erfindungsgemäß verwendbare flüchtige Jodverbindung zur Verfügung, die zudem eine hohe Jodausbeute garantiert.

Obwohl die bekannten thermodynamischen Daten der Reaktion von Aluminium mit Jod zu Aluminiumjodid ($Al_2J_6$) eine spontane Reaktion mit isotroper Charakteristik erwarten lassen, zeigt sich, daß bei der Ätzung mit Wasserstoffjodid selbst auf den Aufbau einer dünnen Seitenwandpassivierung verzichtet werden kann. Wie die Versuchsergebnisse zeigen, führt die erfindungsgemäß durchgeführte Ätzung auch ohne zusätzliche Seitenwandpassivierung zu einem streng anisotropen Ätzprofil mit vertikaler Seitenwandstruktur. Eine Analyse im Rasterelektronenmikroskop zeigt desweiteren keine Veränderung der Strukturmaße. Ein Maßgewinn durch eine eventuell aus dem Fotolack stammende Seitenwandpassivierung muß also unterhalb der Nachweisgenauigkeit liegen ( < 30 nm ). Mit einem auf dem Einsatz von Wasserstoffjodid basierenden Ätzprozeß ist somit ohne Seitenwandpassivierung eine anisotrope und streng maßhaltige, dabei aber auch korrosionsfreie Stukturierung von Aluminium und Aluminiumlegierungen im Submikronbereich möglich.

Weiterbildungen der Erfindung sind Gegenstand von Unteransprüchen.

Im folgenden wird die Erfindung anhand eines Ausführungsbeispieles und der Zeichnung näher erläutert. Es zeigen

FIG 1    im Querschnitt den Schichtaufbau einer Kontaktlochebene eines Silizium-Halbleitersubstrats

FIG 2    schematisch die mit dem erfindungsgemäßen Verfahren zu ätzenden Aluminiumstrukturen.

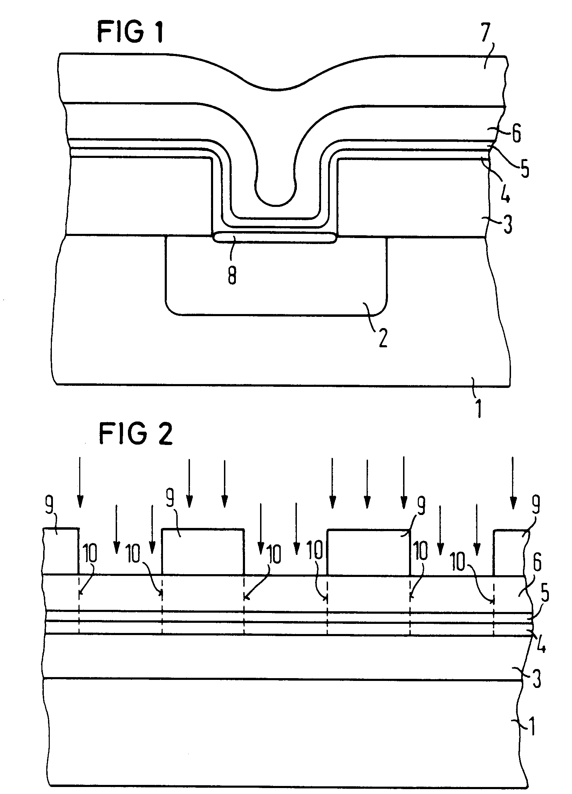

In FIG 1 ist ein heute üblicher Schichtaufbau der Metallisierungsebene eines Aluminiumkontakts eines Halbleitersubstrats 1 dargestellt. Ausgangspunkt ist ein im undotierten Substrat 1 erzeugter wannenförmiger Bereich 2 aus $P^+$ oder $n^+$ dotiertem Silizium, der kontaktiert werden soll. Die Aluminium-Kontaktierung ist als mehrlagige Metallisierungsschicht ausgeführt:

- die (untere) Titan-Schicht 4 dient zur Verbesserung des Kontaktwiderstandes durch Erzeugung eines Titansilizid-Interfaces 8 infolge thermischer Behandlung.

- die (mittlere) Titannitrid-Schicht 5 ist als Diffusionsbarriere gegen Diffusion von Aluminium in Silizium und umgekehrt vorgesehen. Andernfalls könnten sich sog. spikes von erheblichen Ausmaßen bilden und den Kontakt zerstören. Die Verwendung von Ti bzw. TiN-Schichten als Diffusionsbarriere bei Aluminiumleitbahnen ist aus der europäischen Patentanmeldung 0 304 728 bekannt.

- die (obere) Al-Si-Cu-Schicht 6 dient als Leiterbahnebene zum Stromtransport. Die Silizium-Beimischung hat dabei das Ziel, die Lösung von Substrat-Silizium in Aluminium zu verhindern. Der Kupfer-Ligand dient zur Verbesserung der Elektromigrationseigenschaften. Auch andere Liganden sind möglich.

Oberhalb der mehrlagigen Metallisierungsschicht ist noch eine $SiO_2$-Schicht 7 als Isolationschicht gegen darüberliegende Metallebenen und zur Planarisierung aufgebracht. Zwischen der Metallisierungsebene und dem Substrat 1 befindet sich ein Isolationsoxid 3, z. B. Borphosphorsilikatglas.

In FIG 2 ist die Übertragung des Maskenmusters der in diesem Fall aus Fotolack bestehenden Ätzmaske 9 auf die mehrlagige Metallisierungsschicht schematisch dargestellt. Dabei haben gleiche Bezugszeichen die gleiche Bedeutung wie in FIG 1. Als Ätzmaske 9 kann jedoch auch eine mittels einer Photolackmaske strukturierte Hartmaske vorzugsweise aus $SiO_2$ oder $Si_3N_4$, verwendet werden. Die Pfeile in FIG 1 sollen die vertikal von oben einfallenden Ionen und die strichlierten Linien den Verlauf der Ätzung andeuten. Beim erfindungsgemäßen Ätzen mit einer Wasserstoffjodid enthaltenden Ätzgasmischung erfolgt ein streng anisotroper Ätzangriff ohne laterale Ätzkomponente, so daß ohne schützende aber nachteilige Seitenwandpassivierung eine genau definierte vertikale Flankenform 10 der aus der mehrlagigen Metallisierungsschicht aufgebauten Leiterbahnen ausgebildet wird. Da Wasserstoffjodid bei Normalbedingungen einen genügend hohen Dampfdruck besitzt, läßt sich der erfindungsgemäße Ätzprozeß ohne zusätzliche Heizmaßnahmen durchführen. Die strenge Anisotropie des erfindungsgemäßen Verfahrens geht nicht primär auf die physikalische Ätzkomponente zurück, so daß das Verfahren auf einfache Weise mit einem Standard RIE-Trockenätzer (Tylan/Tokuda HIRRIE 100) durchgeführt werden kann. Eine Verwendung eines anderen RIE-Typs oder komplizierterer und aufwendigerer Reaktoren des MERIE- oder ECR-Typs ist ebenfalls möglich. Dadurch, daß nicht die physikalische Komponente primär zur Erzielung der Anisotropie beiträgt, ist es jedoch möglich, die Energie der auftreffenden Ionen gering zu halten, wodurch die Gefahr des Verbrennens der Fotolackmaske infolge der durch Ionenbeschuß übertragenen kinetischen Energie verringert wird. Die Strukturierung der Mehrlagenmetallisierung kann beispielsweise mit einer Deep-UV-gehärteten Fotolackmaske erfolgen.

In den Versuchen wurden folgende typische Hauptprozeßparameter festgelegt:

| | |
|---|---|
| Prozeßdruck: | 1 bis 150 Pa |
| HJ-Fluß: | 5 bis 1000 sccm |
| RF-Leistung: | 50 bis 600 W (bei 13,56 MHz) |
| Scheibentemperatur: | - 20° C bis 80° C |

Maschinenspezifische Parameter bei einem anderen Equipment beeinflussen das Prinzip der Ätzung nicht und können jeweils auf einfache Weise optimiert werden. Bei einer hinreichenden Feinabstimmung können dabei auch gute Ergebnisse mit anderen als den zuvorgenannten Hauptparametereinstellungen erzielt werden. Beispielsweise lassen sich dann auch tiefere Scheibentemperaturen als -20° C erreichen, was den Prozeß eher positiv beeinflußt. Um Redepositionen von molekularem Jod an den Kammerwänden zu vermeiden, ist es empfehlenswert, ähnlich wie schon bisher beim Ätzen mit anderen Halogenen, den Reaktor mindestens auf ca. 60° C zu erwärmen.

Ein weiterer unerwarteter Vorteil beim erfindungsgemäß durchgeführten Ätzen ist das Fehlen jeglicher Korrosion. Obwohl für die Versuche ein In-situ-Lackstripp-Prozeß und eine Wasserspülung eingeplant waren, wurde festgestellt, daß auch ohne diese Posttreatmentverfahren keine sichtbare Korrosion auf der Scheibe auftritt (Kontrolle im Lichtmikroskop). Auch nach einer Behandlung mit heißem Wasserdampf ist keine Korrosion festzustellen. Die Korrosionsfreiheit ermöglicht einen äußerst flexiblen Einsatz des erfindungsgemäßen Ätzprozesses, da im Gegensatz zu bisher eingesetzten Prozessen eine Nachbehandlungssequenz mit strenger Zeitkopplung nicht mehr notwendig ist. Auch hierin liegt eine deutliche Verbesserung gegenüber den bisherigen, auf chlor- und bromhaltiger Ätzchemie basierenden Prozessen.

Sollte neben der Anisotropie und der Korrosionsfreiheit zusätzlich die Optimierung anderer Eigenschaften des Ätzprozesses erwünscht sein, so ist dies auf einfache Weise durch Beimischung einer halogenhaltigen, bzw. einer einfachen Kohlenstoff-, Stickstoff- oder Sauerstoffverbindung zur Ätzgasmischung möglich. Außerdem kann der Ätzzusammensetzung ohne weiteres ein inertes Trägergas, z. B. ein Edelgas (He, Ar, Kr, Ne), oder Stickstoff bzw. Wasserstoff beigemischt werden. Diese Trägergase können zur Initialisierung des Ätzprozesses und zur Stabilisierung des Plasmas beitragen. Auch die Beimischung von Sauerstoff ist möglich, wobei der Parameterraum des Ätzprozesses dann aber auf ein sehr schmales Fenster begrenzt ist.

Wie erwähnt, treten beim bekannten Ätzen mit Chlorchemie insofern Probleme mit der Homogenität der Ätzung einer mehrlagigen Metallisierungsschicht auf, da an manchen Stellen der Scheibe noch Aluminium geätzt wird, während an anderen Stellen die Ti/TiN-Barriere schon vollständig entfernt wurde. In der Überätzphase zur Entfernung von Si- bzw. Cu-Resten wird dadurch die darunterliegende Oxidschicht stark unterschiedlich gedünnt. Derartige Inhomogenitäten treten aufgrund der Inhomogenität der Al-Schicht selbst, vor allem aber wegen der Topographie der Leiterbahnen (z. B. Stufen) auf. Die erfindungsgemäße Verwendung einer jodhaltigen Ätzchemie löst auch dieses Problem, da aufgrund der sehr hohen Selektivität der Ätzprozeß auf der TiN-Schicht abgestoppt wird. Die Ti-Schichten können anschließend bequem mittels eines sehr homogenen zweiten Ätzschrittes (z. B. $CF_4/O_2$) entfernt werden.

**Patentansprüche**

1. Verfahren zum anisotropen Trockenätzen von Aluminium bzw. Aluminiumlegierungen enthaltenden Leiterbahnebenen in integrierten Halbleiterschaltungen, bei dem eine Ätzmaske (9) verwendet wird, **gekennzeichnet** durch das Ätzen mit einer streng anisotrop angreifenden Ätzgasmischung, die eine bei Normalbedingungen flüchtige Jodverbindung enthält, wobei eine genau definierte vertikale Flankenform (10) der Leiterbahnen ausgebildet wird.

2. Verfahren nach Anspruch 1,
   **dadurch gekennzeichnet,**
   daß die Ätzgasmischung Wasserstoffjodid enthält.

3. Verfahren nach Anspruch 1 oder 2,
   **dadurch gekennzeichnet,**
   daß die Ätzgasmischung zusätzlich zur Jodverbindung mindestens eine halogenhaltige Verbindung enthält.

4. Verfahren nach einem der Ansprüche 1 bis 3,
   **dadurch gekennzeichnet,**
   daß die Ätzgasmischung zusätzlich eine einfache Kohlenstoff-, Stickstoff- oder Sauerstoffverbindung, vorzugsweise $N_2O$, $CO$, $CO_2$ oder $CH_4$, enthält.

5. Verfahren nach einem der Ansprüche 1 bis 4,
   **dadurch gekennzeichnet,**
   daß die Ätzgasmischung Stickstoff, Sauerstoff oder Wasserstoff, oder ein Edelgas, vorzugsweise Helium oder Argon, als Trägergas enthält.

6. Verfahren nach einem der Ansprüche 1 bis 5,
   **dadurch gekennzeichnet,**
   daß als Material für die Leiterbahnebenen eine Aluminiumlegierung verwendet wird, die Silizium und/oder Kupfer enthält.

7. Verfahren nach einem der Ansprüche 1 bis 6,
   **dadurch gekennzeichnet,**
   daß die Leiterbahnebenen durch plasmaunterstützes reaktives Ionenätzen geätzt werden.

8. Verfahren nach einem der Ansprüche 1 bis 7,
   **dadurch gekennzeichnet,**
   daß als Ätzmaske (9) eine Photolackschicht verwendet wird.

9. Verfahren nach einem der Ansprüche 1 bis 7,
   **dadurch gekennzeichnet,**
   daß als Ätzmaske (9) eine mittels einer Photolackmaske strukturierte Hartmaske, vorzugsweise aus $SiO_2$ oder $Si_3N_4$, verwendet wird.

10. Verwendung des Ätzverfahrens nach einem der Ansprüche 1 bis 9 zum streng anisotropen Ätzen von Aluminiumleiterbahnen ohne Seitenwandpassivierung und ohne Korrosion, insbesondere im Submikronbereich.

FIG 1

FIG 2